# EUROPEAN PATENT APPLICATION

(11) **EP 3 109 341 A1**
(43) Date of publication of application: **28.12.2016**
(21) Application number: 15752099.0
(22) Date of filing: 19.02.2015
(51) Int. Cl.: C23C 14/06, B23B 27/14, B32B 15/01

(54) **HARD COATING FILM AND METHOD OF FORMING SAME**

(30) Priority: 21.02.2014 JP 2014032280
(71) Applicant: Kabushiki Kaisha Kobe Seiko Sho (Kobe Steel, Ltd.), Kobe-shi, Hyogo 651-8585 (JP)
(72) Inventor: NII Hiroaki, Nishi-ku Kobe-shi Hyogo 651-2271 (JP); YAMAMOTO Kenji, Nishi-ku Kobe-shi Hyogo 651-2271 (JP)
(74) Representative: Müller-Boré & Partner Patentanwälte PartG mbB
(86) International application number: PCT/JP2015/054694
(87) International publication number: WO 2015/125898

(57) **Abstract**

The present invention relates to a hard coating film that is formed on a substrate, that is provided with a layer (A) of which the composition is [Ti(BCN)] and a layer (B) of which the composition is [TiAl(CN)], [AlCr(CN)], [TiCrAlSi(CN)], or [TiSi(CN)], and that is characterized in that: a foundation layer comprising the layer (B) is formed on the substrate; an adhesion-reinforcing layer in which the layer (A) and the layer (B) are stacked repeatedly in an alternating manner is formed on the foundation layer; the thickness of the layer (A) increases compared to the foundation layer (2) side as the thickness of the adhesion-reinforcing layer increases; and the maximum thickness of the layer (A) is 20-50 nm. The hard coating film is formed on the substrate surface of a jig tool or the like, has high coating film hardness, and exhibits excellent adhesion and wear resistance during cutting and the like.

## Description

### TECHNICAL FIELD

The present invention relates to a hard film formed on a substrate surface of a tool such as a cutting tool or a die, particularly a tool formed of a non-ferrous metal material, and a method for manufacturing the same.

### BACKGROUND ART

In order to improve wear resistance in cutting and the like, a hard film formed of, for example, TiB₂ or the like is commonly formed on a surface of a substrate of a tool. Then, technologies for forming such hard films are disclosed in Patent Documents 1 to 4.

Patent Document 1 discloses a cutting tool insert including a substrate and a film containing at least one TiB₂ layer. Further, Patent Document 2 discloses a cutting tool in which a hard covering layer is formed by vapor deposition on a surface of a tool substrate formed of a cubic boron nitride-based material sintered under an ultrahigh pressure, and discloses that the hard film layer is composed of a lower layer formed of a TiB₂ layer, an intermediate layer formed of a two-phase mixed layer of a TiB₂ layer and a TiN layer, and an upper layer formed of a complex nitride layer of Ti and Al.

Patent Document 3 discloses a film made by laminating a layer A composed of a metal boride and a layer B containing carbon on each other. Further, Patent Document 4 discloses a laminate including a laminated part formed of at least two kinds of compound layers mainly composed of one or more first elements selected from the group 4a, 5a and 6a elements in the periodic table, Al, Si and B, and one or more second elements selected from B, C, N and O, and an intermediate layer composed of one or more third elements selected from the group 4a, 5a and 6a elements in the periodic table and one or more fourth elements selected from C, N and O.

### PRIOR ART DOCUMENTS

### PATENT DOCUMENTS

Patent Document 1: JP-A-2002-355704
Patent Document 2: JP-A-2010-228032
Patent Document 3: JP-A-2009-79266
Patent Document 4: JP-A-H08-127862

### SUMMARY OF THE INVENTION

### PROBLEMS THAT THE INVENTION IS TO SOLVE

However, in the cutting tool insert of Patent Document 1, the film formed on the substrate formed of a cemented carbide and the like contains the TiB₂ layer. The TiB₂ layer is different from the substrate in crystal structure, so that adhesion thereof to the substrate is liable to be decreased. For this reason, the film described in Patent Document 1 has a problem of having inferior adhesion during cutting and the like.

In the cutting tool of Patent Document 2, the upper layer of the hard film layer acting as a working surface in cutting and the like has a composition of TiAlN. The film having the composition of TiAlN is easy to wear in cutting and the like of a non-ferrous metal material. For this reason, the hard covering layer described in Patent Document 2 has a problem of having inferior wear resistance during cutting and the like.

In the film of Patent Document 3, the film is formed of the metal boride and the carbide, and the metal boride and the carbide are low in adhesion to the substrate formed of a cemented carbide and the like. For this reason, the film described in Patent Document 3 has a problem of having inferior adhesion during cutting and the like.

In the laminate of Patent Document 4, the laminated part acting as a working surface in cutting and the like has a composition of TiN or AlN. The film having the composition of TiN or AlN is easy to wear in cutting and the like. For this reason, the laminate described in Patent Document 4 has a problem of having inferior wear resistance during cutting and the like.

The present invention has been made in view of the above-mentioned situation, and objects thereof are to provide a hard film formed on a substrate surface of a tool, having high film hardness and having excellent adhesion and wear resistance during cutting and the like, and to provide a method for forming the same.

### MEANS FOR SOLVING THE PROBLEMS

The hard film in the present invention in order to solve the problems is a hard film to be formed on a substrate, the hard film including: a layer A having a composition of Ti_{w}(BₓC_{1-x-y}N_{y})_{1-w} satisfying0.2≤w≤0.6, 0.1≤x≤0.8, 0≤y≤0.5 and 0≤1-x-y≤0.5; and a layer B having a composition of any one of Ti₁₋ₐAlₐ(C₁₋ₖNₖ), Al_{b}Cr_{1-b}(C₁₋ₖNₖ), Ti_{1-c-d-e}Cr_{c}Al_{d}Siₑ(C₁₋ₖNₖ) and Ti_{1-f}Si_{f}(C₁₋ₖNₖ), which satisfies 0.3≤a≤0.7, 0.3≤b≤0.8, 0.3≤d≤0.7, c≤0.3, 0≤e≤0.3, 1-c-d-e≤0.3, 0.05≤f≤0.3 and 0.5≤k≤1, wherein an underlying layer formed of the layer B is formed on the substrate, and an adhesion reinforcing layer in which the layers A and the layers B are alternately repeatedly laminated on one another is formed on the underlying layer, and
the layer A is increased in thickness compared to that on the underlying layer side with an increase in thickness of the adhesion reinforcing layer, and a maximum thickness of the layer A is 20 to 50 nm.

The above-mentioned hard film includes the layer A and the layer B each having the predetermined composition, thereby increasing hardness of the hard film and improving wear resistance of the hard film. Further, the above-mentioned hard film includes the underlying layer formed of the layer B, thereby improving adhesion between the film and the substrate. Furthermore, the above-mentioned hard film includes the adhesion reinforcing layer in which the layers A and the layers B are alternately repeatedly laminated on one another, the layer A is increased in thickness compared to that on the underlying layer side with an increase in the thickness of the adhesion reinforcing layer, and the maximum thickness thereof reaches the predetermined thickness, thereby improving the adhesion of the hard film and improving cutting performance to improve the wear resistance.

In the hard film in the present invention, it is preferred that a layer C is further formed on the above-mentioned adhesion reinforcing layer, and the above-mentioned layer C having a composition of TiB₂, and the thickness of the above-mentioned layer C is 5.0 µm or less. The above-mentioned hard film includes the layer C composed of TiB₂, and thickness of the layer C is adjusted to the predetermined range, thereby preventing breakage (chipping) of the hard film and improving the wear resistance of the hard film.

The first method for forming the hard film in the present invention includes: a substrate preparation step of preparing the substrate; a substrate heating step of heating the substrate; and a film forming step of forming the hard film on the substrate, and in the film forming step, the underlying layer and the adhesion reinforcing layer are formed by at least one of an arc ion plating process and a sputtering process.

In the above-mentioned first method for forming the hard film, the film forming step is performed by at least one of the arc ion plating process and the sputtering process, thereby forming the hard film including the underlying layer formed of the layer B having the predetermined composition and the adhesion reinforcing layer in which the layers A having the predetermined composition and the layers B having the predetermined composition are alternately repeatedly laminated on one another. This increases the hardness of the hard film and improves the wear resistance of the hard film. Further, in the first method for forming the hard film, the layer A is formed in a state where a predetermined bias voltage is applied on the substrate, thereby improving the wear resistance of the hard film.

The second method for forming the hard film in the present invention includes: a substrate preparation step of preparing the substrate; a substrate heating step of heating the substrate; and a film forming step of forming the hard film on the substrate, and in the film forming step, the underlying layer, the adhesion reinforcing layer and the layer C are formed by at least one of an arc ion plating process and a sputtering process.

In the above-mentioned second method for forming the hard film, the film forming step is performed by at least one of the arc ion plating process and the sputtering process, thereby forming the hard film including the underlying layer formed of the layer B having the predetermined composition, the adhesion reinforcing layer in which the layers A having the predetermined composition and the layers B having the predetermined composition are alternately repeatedly laminated on one another, and the layer C composed of TiB₂. This increases the hardness of the hard film and improves the wear resistance of the hard film. Further, in the second method for forming the hard film, the layer A and the layer C are formed in a state where a predetermined bias voltage is applied on the substrate, thereby improving the wear resistance of the hard film.

### ADVANTAGEOUS EFFECTS OF THE INVENTION

In the hard film of the present invention, it is formed on a substrate surface of a tool, and has high film hardness and excellent adhesion and wear resistance during cutting and the like. Further, in the forming method of the hard film of the present invention, the hard film having high hardness and excellent adhesion and wear resistance during cutting and the like can be formed.

### BRIEF DESCRIPTION OF THE DRAWINGS

[FIG. 1] FIG. 1 is a cross-sectional view showing a first embodiment of a hard film in the present invention.
[FIG. 2] FIG. 2 is a cross-sectional view showing a second embodiment of a hard film in the present invention.
[FIG. 3] FIG. 3 is a diagram schematically illustrating a film deposition apparatus.

### MODE FOR CARRYING OUT THE INVENTION

A first embodiment of a hard film in the present invention will be described with reference to the drawing.

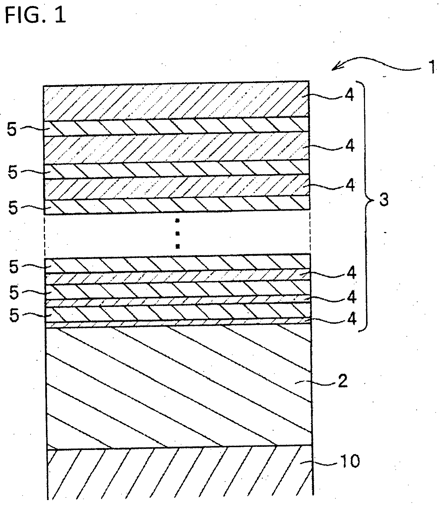

As shown in FIG. 1, a hard film 1 is a film formed on a substrate 10 for improving adhesion and wear resistance, and includes an underlying layer 2 and an adhesion reinforcing layer 3 formed on the underlying layer 2.

### <Substrate>

Examples of the substrates 10 include cemented carbides, iron-based alloys, cermets, high-speed tool steels and the like. However, the substrates 10 should not be limited thereto, and may be tools such as cutting tools such as chips, drills and end mills, press dies, forging dies, molding dies and blanking punches.

### <Underlying layer>

The underlying layer 2 is a film formed on the substrate 10, and is formed of a layer B having a predetermined composition. The adhesion between the substrate 10 and the hard film 1 is improved by the formation of the underlying layer 2. For this reason, the thickness of the underlying layer 2 is preferably from 0.1 to 5 µm. The details of the composition of the layer B will be described later.

### <Adhesion reinforcing layer>

The adhesion reinforcing layer 3 is a film formed on the underlying layer 2, and is formed by alternately repeatedly laminating layers A 4 having a predetermined composition and layers B 5 having a predetermined composition on one another. Then, the layer A 4 is increased in thickness compared to that on the underlying layer 2 side with an increase in the thickness of the adhesion reinforcing layer 3, and the adhesion reinforcing layer 3 is formed so that the maximum thickness of the layer A 4, that is, the thickness of the uppermost layer of the layers A 4 in the adhesion reinforcing layer 3, is 20 to 50 nm. It is more preferably from 20 to 40 nm. The minimum thickness of the layer A 4, that is, the thickness of the lowermost layer of the layers A 4, which is in contact with the substrate 10, in the adhesion reinforcing layer 3, is not particularly limited. However, it is preferably from 0.1 to 20 nm, and more preferably from 0.5 to 10 nm. The layers A 4 are preferably increased in thickness for each lamination (for each layer). However, they may be increased in thickness for each two or more layers, although not shown. For example, the first and second layers are the same in thickness, and the third layer may be increased in thickness compared to the first and second layers. Further, the thickness of the layers B 5 in the adhesion reinforcing layer 3 is preferably constant for each lamination and from 5 to 50 nm. It is more preferably from 10 to 40 nm.

In the adhesion reinforcing layer 3, it is preferred to laminate the layers A 4 and the layers B 5 in such a manner that the layer A 4. is disposed on the substrate 10 side thereof and that the layer A 4 is disposed on the outermost surface side. However, the layer B 5 may be disposed on the outermost surface side of the adhesion reinforcing layer 3, although not shown. The thickness of the adhesion reinforcing layer 3, that is, the total thickness of the layers A 4 and the layers B 5 laminated on one another is preferably from 0.5 to 10 µm, and more preferably from 0.5 to 5 µm.

The layer A 4 is a film having heat resistance, high hardness and excellent wear resistance. However, when it is used as a single layer, there is a problem in further improvement of the wear resistance, because of a problem of the adhesion to the substrate 10 and a problem of crystal orientation. The layer B 5 is a film having oxidation resistance and high toughness. However, when it is used alone, there is a problem that the wear resistance thereof is inferior to that of the layer A 4. In the present invention, the adhesion reinforcing layer 3 in which the layers A 4 and the layers B 5 are alternately repeatedly laminated on one another is formed, the layers A 4 are increased in thickness compared to that on the underlying layer 2 side with an increase in the thickness of the adhesion reinforcing layer 3, and the maximum thickness thereof reaches the predetermined thickness, thereby being able to control crystal orientation of the layers A 4 and the layers B 5. That is, in each layer B 5, coarse crystal grains unidirectionally grow, so that adhesion thereof to an upper layer is decreased as it is. Accordingly, by gradually increasing the thickness of each layer A, the crystal grains in the layer B continue to unidirectionally grow while the thickness of the layer A is thin, and unidirectional growth of the coarse crystal grains in the layer B is suppressed with an increase in thickness of the layer A. As a result, an influence from a lower layer (a layer on the underlying layer 2 side) on the unidirectional growth in the layer B is weakened with an increase in thickness of the layer A, and the size of the crystal grains in the layer B is refined. The adhesion of the hard film 1 is improved thereby compared to a hard film having a single layer structure of the layer A 4 and the layer B 5, and cutting performance is remarkably improved, resulting in improvement of the wear resistance of the hard film 1.

In order to control the grain size in the layers B 5, it is preferred that the thickness of the layers A 4 in the adhesion reinforcing layer 3 is increased stepwise. For example, the thickness of the layers A 4 is preferably increased by 0.1 to 20 nm for each lamination (for each layer or for each two or more layers). When the maximum thickness of the layers A 4 in the adhesion reinforcing layer 3 is less than 20 nm, improvement of the cutting performance of the adhesion reinforcing layer 3 is not recognized, and improvement of the wear resistance of the hard film 1 is not recognized. When the maximum thickness of the layers A 4 is more than 50 nm, it is difficult to form the layers A 4, also resulting in high cost. The above-mentioned thickness of the layers A 4 is controlled by the amount of evaporation of a layer A target in manufacturing of the hard film 1 (in layer A formation) described later, or the like.

### (Layer A)

The layer A 4 is a film having a composition of Ti_{w}(B, C, N)_{1-w} satisfying 0.2≤w≤0.6 (0.4≤1-w≤0.8).

Non-metallic components (B, C and N) are elements added for imparting high hardness and wear resistance to the layer A 4, and a metallic component (Ti) is an element added for adjusting the content of the non-metallic components (B, C and N). When the atomic ratio (w) of the metallic component (Ti) is more than 0.6, the atomic ratio (1-w) of the non-metallic components (B, C and N) is less than 0.4 to decrease the hardness and wear resistance of the layer A 4. Further, when the atomic ratio (w) of the metallic component (Ti) is less than 0.2, the atomic ratio (1-w) of the non-metallic components (B, C and N) is more than 0.8 to decrease the hardness and wear resistance of the layer A 4.

The layer A 4 is a film in which the atomic ratio in the nonmetallic components is (BₓC_{1-x-y}N_{y}) and satisfying 0.1≤x≤0.8, 0≤y≤0.5 and 0≤1-x-y≤0.5.

In order to impart high hardness and wear resistance to the layer A 4, the atomic ratio (x) of B must be at least from 0.1 to 0.8. Preferably, the atomic ratio (x) of B is from 0.25 to 0.75. Further, in order to further increase the hardness of the layer A 4, the atomic ratio (1-x-y) of C may be 0.50 or less, and the atomic ratio (y) of N may be 0.50 or less.

### (Layer B)

The layer B 5 is a film having a composition composed of metallic components (Ti, Al, Cr and Si) and non-metallic components (C and N) and being any one of the following four kinds.

### (1) A film having a composition of Ti₁₋ₐAlₐ(C₁₋ₖNₖ) satisfying 0.3≤a≤0.7 and 0.5≤k≤1

In order to impart high hardness and wear resistance to the layer B 5, the atomic ratio (1-a) of Ti as the metallic component must be from 0.3 to 0.7, and the atomic ratio (a) of Al must be from 0.3 to 0.7. Further, in order to impart high hardness and wear resistance to the layer B 5, at least the atomic ratio (k) of N as the non-metallic component must be from 0.5 to 1. Furthermore, in order to further increase the hardness of the layer B 5, the atomic ratio (1-k) of C as the non-metallic component may be 0.5 or less.

### (2) A film having a composition of Al_{b}Cr_{1-b}(C₁₋ₖNₖ) satisfying 0.3≤b≤0.8 and 0.5≤k≤1

In order to impart high hardness and wear resistance to the layer B 5, the atomic ratio (b) of Al as the metallic component must be from 0.3 to 0.8, and the atomic ratio (1-b) of Cr must be from 0.2 to 0.7. Further, in order to impart high hardness and wear resistance to the layer B 5, at least the atomic ratio (k) of N as the non-metallic component must be from 0.5 to 1. Furthermore, in order to further increase the hardness of the layer B 5, the atomic ratio (1-k) of C as the non-metallic component may be 0.5 or less.

### (3) A film having a composition of Ti_{1-c-d-e}Cr_{c}Al_{d}Siₑ(C₁₋ₖNₖ) satisfying c≤0.3, 0.3≤d≤0.7, 0≤e≤0.3, 1-c-d-e≤0.3 and 0.5≤k≤1

In order to impart high hardness and wear resistance to the layer B 5, the atomic ratio (1-c-d-e) of Ti as the metallic component must be 0.3 or less, the atomic ratio (c) of Cr must be 0.3 or less, and the atomic ratio (d) of Al must be from 0.3 to 0.7. Further, in order to impart high hardness and wear resistance to the layer B 5, at least the atomic ratio (k) of N as the non-metallic component must be from 0.5 to 1. Furthermore, in order to further impart the wear resistance to the layer B 5, the atomic ratio (e) of Si as the metallic component may be 0.3 or less. In addition, in order to further increase the hardness of the layer B 5, the atomic ratio (1-k) of C as the non-metallic component may be 0.5 or less.

### (4) A film having a composition of Ti_{1-f}Siₜ(C₁₋ₖNₖ) satisfying 0.05≤f≤0.3 and 0.5≤k≤1

In order to impart high hardness and wear resistance to the layer B 5, the atomic ratio (1-f) of Ti as the metallic component must be from 0.7 to 0.95, and the atomic ratio (f) of Si must be from 0.05 to 0.3. Further, in order to impart high hardness and wear resistance to the layer B 5, at least the atomic ratio (k) of N as the non-metallic component must be from 0.5 to 1. Furthermore, in order to further increase the hardness of the layer B 5, the atomic ratio (1-k) of C as the non-metallic component may be 0.5 or less.

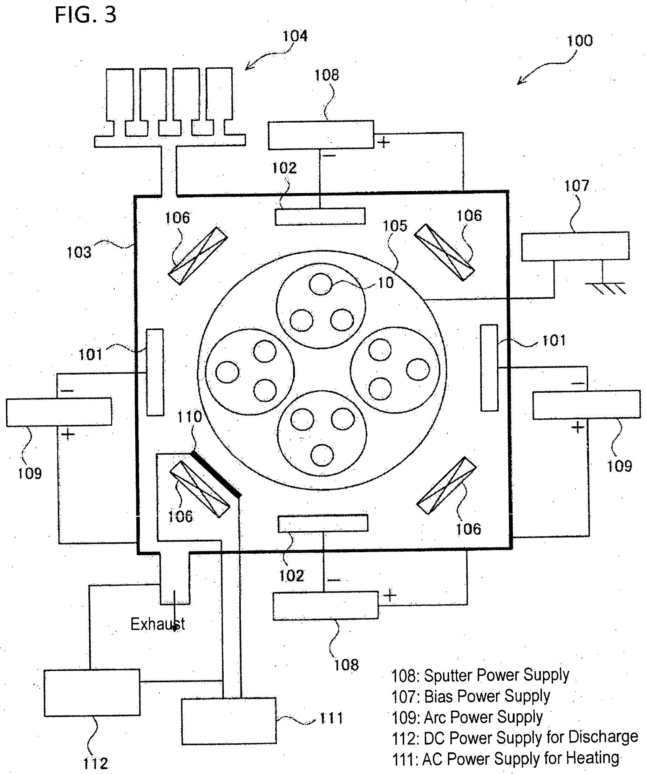

In the above-mentioned underlying layer 2, layer A 4 and layer B 5, the atomic ratios (w, x, y, a, b, c, d, e and f) of Ti, B, C, N, Al, Cr and Si are controlled by a composition of a target set to a film deposition apparatus 100 (see FIG. 3) in the production of the hard film 1 (a film forming step) described later. Further, the atomic ratios (x, y and k) of C and N may be controlled by the introduction amount of inert gases such as nitrogen and hydrocarbons introduced into the film deposition apparatus 100. Then, the thickness of the underlying layer 2, the layer A 4 and the layer B 5 is controlled by the evaporation amount of the target during the film formation, or the like.

A second embodiment of a hard film in the present invention will be described with reference to the drawing.

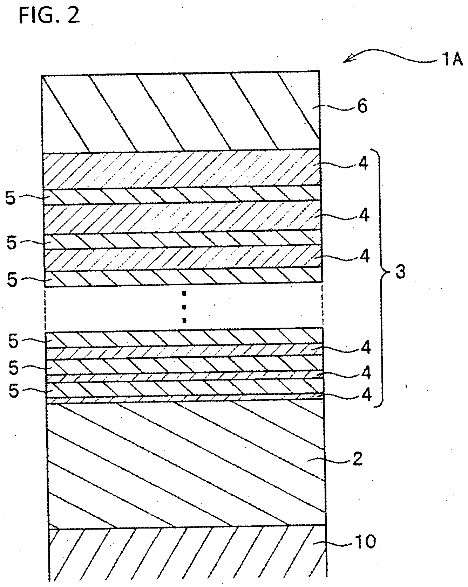

As shown in FIG. 2, a hard film 1A includes an underlying layer 2, an adhesion reinforcing layer 3 formed of layers A 4 and layers B 5, and a layer C 6 formed on the adhesion reinforcing layer 3. The hard film 1A includes the layer C 6, thereby further improving the wear resistance.

The adhesion reinforcing layer 3 formed of the underlying layer 2, the layers A 4 and the layers B 5 is the same as in the case of the hard film 1 of the first embodiment described above, so that the description thereof is omitted.

### (Layer C)

The layer C 6 has a composition of TiB₂, and the thickness thereof is 5.0 µm or less and preferably 3.0 µm or less. When the thickness is more than 5.0 µm, breakage (chipping) of the layer C 6 occurs by internal stress to decrease the wear resistance of the hard film 1A. Further, although the lower limit of the thickness is not particularly limited, it is preferably 0.3 µm or more in terms of easy formation of the layer C 6. The thickness of the layer C 6 is controlled by the amount of evaporation of a target (TiB₂) set to the film deposition apparatus 100 (see FIG. 2), during the film formation, in the production of the hard film 1A (the film forming step).

In the layer C 6, the cutting performance of the layer C 6 varies depending on the integral intensity ratio of diffraction lines when measured by X-ray diffraction, that is, preferential orientation. In the layer C 6, the cutting performance of the layer C 6 is improved by improving orientation of a (100) plane or a (001) plane. The preferential orientation of the layer C 6 depends on the bias voltage applied to the substrate 10 during the formation of the layer C 6, and varies from (001) plane orientation to (100) plane orientation with -50 V as a boundary, with an increase in negative bias voltage.

Accordingly, when the integral intensity of a diffraction line from a (100) plane when measured by X-ray diffraction of a θ-2θ process is defined as I(100) and the integral intensity of a diffraction line from a (001) plane is defined as I(001), it is preferred that the layer C 6 satisfies I(100)/I(001)<1, when the bias voltage is -50 V or more and less than 0 V, and satisfies I(100)/I(001)≥1, when the bias voltage is -150 V or more and less than -50 V using an unbalanced magnetron sputtering (UBMS) power supply as a sputtering power supply as described later. When the bias voltage is -100 V or more and less than -50 V using a dual magnetron sputtering (DMS) power supply described in a reference literature (Takuji Oyama, Past, Present and Future of Dry Coating Technology, Res. Reports Asahi Glass Co., Ltd., 57 (2007), pp. 83-90), it is preferred to satisfy I(100)/I(001)≥1. Like this, by adjusting the integral intensity ratio to the predetermined value range by the bias voltage, the hardness of the layer C 6 is increased, and the cutting performance is improved to improve the strength and wear resistance of the hard film 1A.

Then, there is described a first method for forming the hard film in the present invention, that is, a forming method of the hard film of the first embodiment. For the structure of the hard film 1, reference is made to FIG. 1. The forming method of the hard film 1 includes a substrate preparation step, a substrate heating step and a film forming step.

### (Substrate preparation step)

The substrate preparation step is a step of preparing the substrate 10 having a predetermined size, with cleaning with ultrasonic waves or the like as needed.

### (Substrate heating step)

The substrate heating step is a step of heating the substrate 10 after introduction into the film deposition apparatus 100 as shown in FIG. 3, and the substrate 10 is preferably heated so as to be kept at a predetermined temperature, for example, 500 to 550°C. Heating of the substrate 10 makes it easy to form the hard film 1 on the substrate 10 in the subsequent step.

### (Film forming step)

The film forming step is a step of forming the hard film 1 on the substrate 10 by using at least one of an arc ion plating process (AIP process) and a sputtering process (SP process). Specifically, the underlying layer 2 is formed on the substrate 10 by the AIP process or the SP process, and the adhesion reinforcing layer 3 is formed on the underlying layer 2 by using the SP process or both processes of the AIP process and the SP process. Then, the layers A 4 of the adhesion reinforcing layer 3 are formed by the SP process, and the layers B 5 of the adhesion reinforcing layer 3 are formed by the AIP process or the SP process. Further, when the layers A 4 are formed by the SP process, a bias voltage of -200 V or more and less than 0 V is preferably applied to the substrate 10.

Furthermore, in the forming method of the hard film 1 of this embodiment, in addition to the above-mentioned steps, a substrate etching step may be contained between the substrate heating step and the film forming step. The substrate etching step is a step of etching a surface of the substrate 10 with ions of a rare gas such as Ar.

Then, the case of using the film deposition apparatus 100 shown in FIG. 3 is described as an example of the forming method of the hard film 1. The film deposition apparatus should not be construed as being limited thereto.

As shown in FIG. 3, the film deposition apparatus 100 includes a chamber 103 having an exhaust port for vacuum exhaust and a gas supply port 104 for supplying a film forming gas and a rare gas, an arc power supply 109 connected to an arc evaporation source 101, a sputter power supply 108 connected to a sputter evaporation source 102, a substrate stage 105 for supporting the substrate 10 on which the film is to be formed, and a bias power supply 107 for applying negative bias voltage to the substrate 10 through the substrate stage 105 between the substrate stage 105 and the above-mentioned chamber 103. Further, in addition, it includes heaters 106, a DC power supply 112 for discharge, an AC power supply 111 for filament heating and the like.

First, a target for the underlying layer (not shown), which is composed of various metals, alloys or metal compounds, is attached to the arc evaporation source 101 or the sputter evaporation source 102 of the film deposition apparatus 100, and further, the substrate 10 is attached on the substrate stage 105. The inside of the chamber 103 is evacuated (for example, exhausted to 5×10⁻³ Pa or less) to form a vacuum state. Thereafter, Ar is introduced as the rare gas into the chamber 103, and the substrate 10 is heated to a predetermined temperature with the heaters 106 in the chamber 103 to perform etching with Ar ions by an ion source due to thermal electron emission from a filament 110.

Then, the target for the underlying layer is evaporated by the arc power supply 109 or the sputter power supply 108, while introducing the film forming gas (N₂, hydrocarbons and the like) into the chamber 103 as needed, and the substrate stage 105 supporting the substrate 10 is rotated to form the underlying layer 2 having a predetermined thickness on the substrate 10. The thickness of the underlying layer 2 is controlled by the electric power inputted into the arc evaporation source 101 or the sputter evaporation source 102 (the amount of evaporation of the target for the underlying layer) and the rotation speed and rotation number of the substrate stage 105. The higher rotation speed of the substrate stage 105 causes the thinner thickness of the underlying layer 2.

Next, a target for the layer A (not shown), which is composed of various metals, alloys or metal compounds, is attached to the sputter evaporation source 102, and a target for the layer B (not shown), which is composed of various metals, alloys or metal compounds, is attached to the sputter evaporation source 102 or the arc evaporation source 101. Further, the target for the layer A and the target for the layer B are concurrently evaporated by the sputter power supply 108 or the sputter power supply 108 and the arc power supply 109, while introducing the film forming gas into the chamber 103 as needed. At this time, the substrate stage 105 supporting the substrate 10 (a body to be treated) on which the underlying layer 2 is formed is rotated, whereby the adhesion reinforcing layer 3 in which the layers A 4 and the layers B 5 are alternately laminated on one another is formed on the underlying layer. Then, the layers A 4 in the adhesion reinforcing layer 3 are formed so as to increase in thickness for each lamination.

The body to be treated alternately passes in front of the evaporation sources to which the targets having different composition are each attached, with the rotation of the substrate stage 105. At that time, the films corresponding to the target composition of the respective evaporation sources are alternately formed, thereby making it possible to form the adhesion reinforcing layer 3 in which the layers A 4 and the layers B 5 are alternately laminated on one another. Further, the thickness of each of the layers A 4 and the layers B 5 and the amount of increase in thickness of the layers A 4 are controlled by the electric power inputted into each evaporation source (the amount of evaporation of each target) and the rotation speed and rotation number of the substrate stage 105. The higher rotation speed of the substrate stage 105 causes the thinner thickness per layer. The evaporation of the target for the layer A and the target for the layer B is not limited to be concurrently performed, and the evaporation of the target for the layer B may be performed after the formation of the layer A.

During the layer A formation, a bias voltage of -200 V or more and less than 0 V, preferably -150 V or more and -10 V or less is preferably applied to the substrate 10 (the substrate 10 on which the underlying layer 2 is formed) from the bias power supply 107 through the substrate stage 105. Application of a bias voltage within the predetermined range to the substrate 10 improves the cutting performance of the hard film to improve the wear resistance. When the negative voltage of the bias voltage is increased, heating of the substrate 10 during the film formation or a decrease in film formation rate occurs. Accordingly, the layer A is not uniformly formed, and breakage (chipping) becomes liable to occur in the hard film 1 during cutting, resulting in easy deterioration of the wear resistance.

Further, as the sputter power supply 108 used during the layer A formation, there can be used a UBMS power supply (normal power supply) such as UBMS 202 manufactured by Kobe Steel, Ltd., a DMS power supply or the like. The DMS power supply is preferred as the sputter power supply 108. Use of the DMS power supply as the sputter power supply 108 can more improve the hardness and the wear resistance than the case of the normal power supply (UBMS power supply). The reason why the hardness is increased by using the DMS is considered to be that ion irradiation of the target for the layer A is increased by the DMS power supply.

There is described a second forming method of the hard film in the present invention, that is, a forming method of the hard film of the second embodiment. For the structure of the hard film 1A, reference is made to FIG. 2.

The forming method of the hard film 1 A includes a substrate preparation step, a substrate heating step and a film forming step. The substrate preparation step and the substrate heating step are the same as described in the above-mentioned first forming method (the forming method of the hard film 1 described in FIG. 1), so that the descriptions thereof are omitted. Further, the forming method of the hard film 1A may contain the above-mentioned substrate etching step between the substrate heating step and the film forming step.

### (Film forming step)

The film forming step is a step of forming the underlying layer 2 and the adhesion reinforcing layer 3 of the layers A 4 and the layers B 5 on/above the substrate 10 in the same manner as in the first forming method described above, and thereafter forming the layer C 6 on the adhesion reinforcing layer 3 by the SP process or the AIP process. Then, when the layer C 6 is formed by the SP process, the UBMS power supply, the DMS power supply or the like is used as the sputter power supply, and the DMS power supply is preferably used. Then, during the layer C formation, the bias voltage is preferably applied to the substrate 10. When the layer C 6 is formed by the SP process, a bias voltage of -100 V or more and less than 0 V is preferably applied to the substrate 10 in the case of using the DMS power supply, and a bias voltage of -150 V or more and less than 0 V is preferably applied to the substrate 10 in the case of using the UBMS power supply.

In the forming method of the layer C 6 in the film deposition apparatus 100 in FIG. 3, a target for the layer C composed of TiB₂ is attached to the sputter evaporation source 102, the target for the layer C is evaporated by the sputter power supply 108, and the substrate stage 105 supporting the substrate 10 (a body to be treated) on which the underlying layer 2 and the adhesion reinforcing layer 3 are formed is rotated, thereby forming the layer C 6 having a predetermined thickness on the adhesion reinforcing layer 3 of the body to be treated. The thickness of the layer C 6 is controlled by the electric power inputted into the sputter power supply 108 (the amount of evaporation of the target for the layer C) and the rotation speed and rotation number of the substrate stage 105. The higher rotation speed of the substrate stage 105 causes the thinner thickness of the layer C 6.

During the layer C formation, in the case of the DMS power supply, a bias voltage of -100 V or more and less than 0 V, preferably -100 V or more and less than -10 V, more preferably -90 V or more and less than -20 V is preferably applied, and in the case of the UBMS power supply, a bias voltage of -150 V or more and less than 0 V, preferably -120 V or more and less than -20 V is preferably applied, to the substrate 10 (the substrate 10 on/above which the underlying layer 2 and the adhesion reinforcing layer 3 are formed) from the bias power supply 107 through the substrate stage 105.

Application of a bias voltage within the predetermined range to the substrate 10 improves the hardness and the wear resistance of the hard film 1A. When the negative voltage of the bias voltage is increased, the hardness of the layer C 6 is increased. However, heating of the substrate 10 during the film formation or a decrease in film formation rate occurs. Accordingly, the layer C 6 is not uniformly formed, and breakage (chipping) becomes liable to occur in the hard film 1A during cutting, resulting in deterioration of the wear resistance. Further, the reason why hardness is increased by applying the bias voltage is considered to be that the potential difference between the target for the layer C and the substrate 10 is increased to increase ion irradiation of the target for the layer C. Furthermore, when the bias voltage applied to the substrate 10 during the layer C formation is controlled within the predetermined range, preferential orientation of the layer C 6, that is, the integral intensity ratio of diffraction lines measured by X-ray diffraction, is preferably within the predetermined range. Specifically, when the bias voltage is from -50 V or more and less than 0 V, the integral intensity of a diffraction line of a (100) plane is preferably less than 1 time the integral intensity of a diffraction line of a (001) plane, and when the bias voltage is from -150 V or more and less than -50 V using the UBMS power supply, the integral intensity of a diffraction line of a (100) plane is preferably 1.0 time or more the integral intensity of a diffraction line of a (001) plane. When the bias voltage is from -100 V or more and less than -50 V using the DMS power supply, the integral intensity of a diffraction line of a (100) plane is preferably 1.0 time or more the integral intensity of a diffraction line of a (001) plane.

### EXAMPLES

Examples according to the present invention will be described below. In the examples, hard films were formed by using the film deposition apparatus shown in FIG. 3. The present invention should not be construed as being limited to the following examples.

### <First example>

In a first example, film formation was performed using various compositions for both of layers A and layers B. After an underlying layer formed of the layer B was formed to have a thickness of 1.5 µm, an adhesion reinforcing layer was formed to have a thickness of 1.5 µm. A UBMS power supply or a DMS power supply was used for the formation of the layers A in the adhesion reinforcing layer. The film was formed by fixing the bias voltage during the formation of the layer A to -40 V. The layers A and layers B each having different composition were formed, and the thicknesses (the thickness of a lowermost layer, the amount of increase in thickness and the thickness of the uppermost layer (the maximum thickness)) of the layers A in the adhesion reinforcing layer were changed, thereby examining the influence thereof on the hardness, the adhesion and the wear resistance. Further, in comparative examples, the layer A or the layer B was also formed as a single layer having a thickness of 3.0 µm.

Specifically, a cutting tool (chip) and a mirrored cemented carbide test piece (13 mm square × 5 mm thick) as substrates were subjected to ultrasonic cleaning in ethanol, and each substrate was attached to the substrate stage. Further, an underlying layer target (target diameter: 100 mmφ) was attached to the arc evaporation source. After the inside of the film deposition apparatus was exhausted to 5×10⁻³ Pa, the substrate was heated to 500°C, and then, etching with Ar ions was performed for 5 minutes. Thereafter, the substrate stage was rotated at a rotation speed of 5 rpm, and a nitrogen gas or a mixed gas obtained by adding a carbon-containing gas to a nitrogen gas as needed was introduced therein up to 4 Pa. Then, the arc evaporation source was operated at a discharge current of 150 A to form the underlying layer having a thickness of 1.5 µm.

Next, a layer A target (target diameter: 152.4 mmφ) was attached to the sputter evaporation source, a layer B target (the same as the underlying layer target) was attached to the arc evaporation source, and the substrate stage was rotated at a rotation speed of 5 rpm. First of all, only the layer A target was singly evaporated in the predetermined atmosphere of the above-mentioned nitrogen gas or the like for a short period of time, and a bias voltage of -40 V was applied to the substrate to form the layer A (lowermost layer) having a predetermined thickness. Thereafter, an argon gas was introduced, and the layer B target was evaporated, thereby concurrently evaporating the layer A target and the layer B target. The substrate stage was rotated at a rotation speed of 5 rpm while applying a bias voltage of -40 V to the substrate, whereby the adhesion reinforcing layer in which the layers A and the layers B were alternately laminated on one another was formed on the underlying layer so as to give a total thickness of 1.5 µm. Further, the thickness of the lowermost layer, the amount of increase in thickness and the uppermost layer of the layers A and the thickness of the layers B were as shown in Tables 1 to 5.

After the film formation, the component composition in the hard film was measured, and the hardness, the adhesion and the wear resistance were evaluated. The results thereof are shown in Tables 1 to 5.

### (Component composition)

The component composition of the underlying layer and the adhesion reinforcing layer formed of the layers A and the layers B was measured with an EPMA (electron probe micro analyzer).

### (Hardness)

The hardness was measured by a nanoindenter test using the cemented carbide test piece on which the hard film was formed. In the measurement with a nanoindenter, "ENT-1100 manufactured by Elionix Inc." was used as a device, and a Bercovici triangular pyramid indenter was used as the indenter. First, five load application curves were measured for respective loads of 2, 5, 7, 10 and 20 mN. Then, correction of data was performed by the method of correcting the compliance of device and the indenter tip shape, which was proposed by SAWA et al. (J. Mater. Res., Vol. 16, No. 11, 3084 (2001)). One having a hardness of 25 GPa or more was evaluated as good, and one having a hardness of less than 25 GPa was evaluated as poor.

### (Adhesion)

The adhesion was evaluated by a scratch test using the cemented carbide test piece on which the hard film was formed. The scratch test was performed by moving a diamond indenter of 200 µmR on the hard film under conditions of a load increase speed of 100 N/min and an indenter moving speed of 10 mm/min. As the critical load value, a scratched part was observed under an optical microscope after the scratch test, and the load at a part where damage has occurred on the film was employed as the critical load. In Tables 1 to 5, this is described as adhesion force (N). One having an adhesion force of 35 N or more was evaluated as good in adhesion, and one having an adhesion force of less than 35 N was evaluated as poor in adhesion.

### (Wear resistance)

The wear resistance was evaluated by performing a cutting test under the following conditions, using the cutting tool (chip) on which the hard film was formed, and measuring the boundary wear amount (flank wear width) after passage by a predetermined distance. One having a flank wear width of 50 µm or less was evaluated as good in wear resistance, and one having a flank wear width of more than 50 µm was evaluated as poor in wear resistance. One that was unmeasurable due to the occurrence of chipping was evaluated as poor in wear resistance, considering the flank wear amount as being more than 50 µm.

### [Cutting test conditions]

Material to be cut: Ti₆Al₄V
Chip: TH10 (a cemented carbide chip manufactured by Tungaloy Corporation)
Tool: Front mill (manufactured by Sumitomo Electric Industries, Ltd.: FPG 4160R), only one chip was attached to the front mill.
Cutting depth: 1 mm
Feed speed: 157 mm/min
Rotation speed: 1570 rpm
Peripheral speed: 100 m/min
Cutting oil: Almaredge 10%
Evaluation condition: Flank wear width (boundary part) after 7 mm cutting

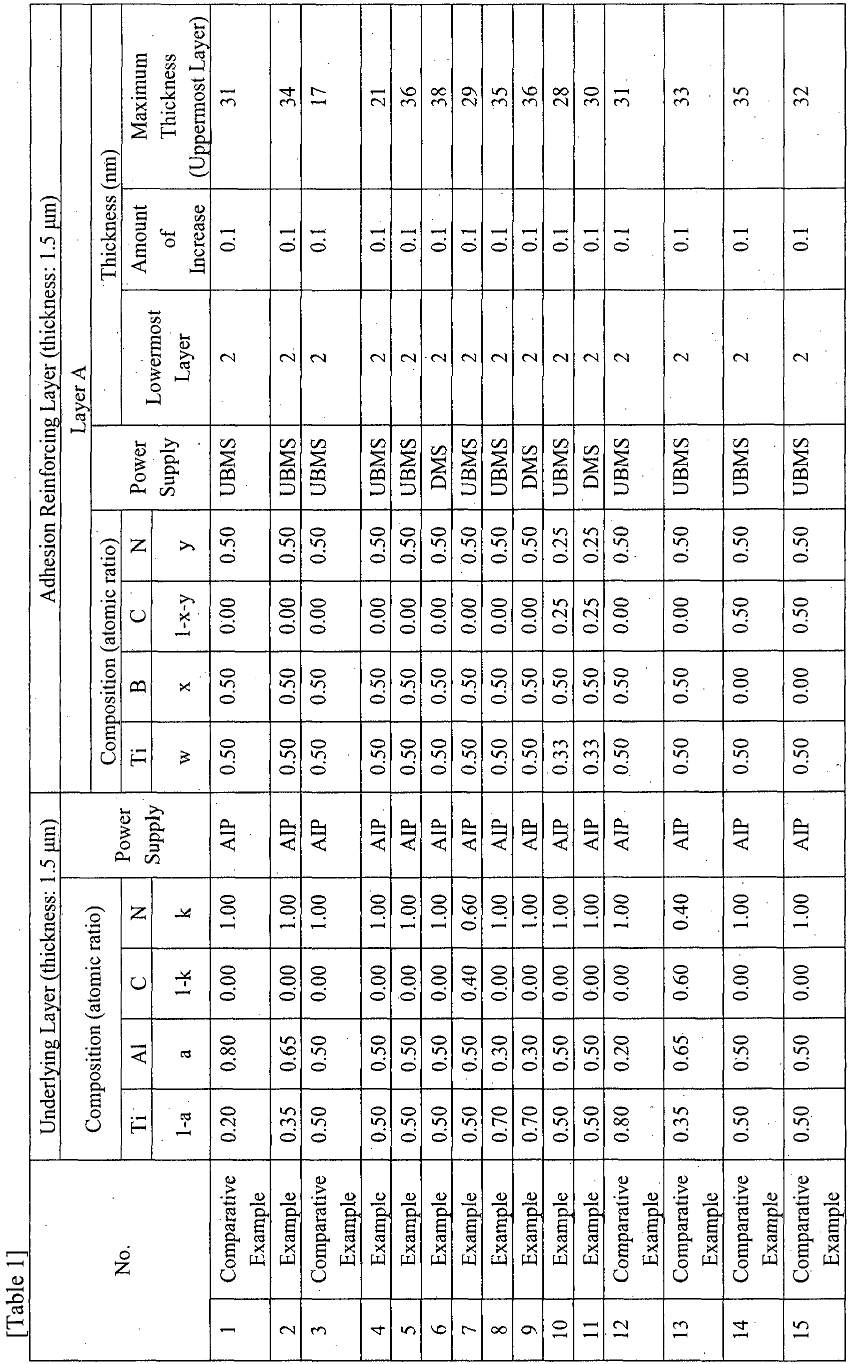

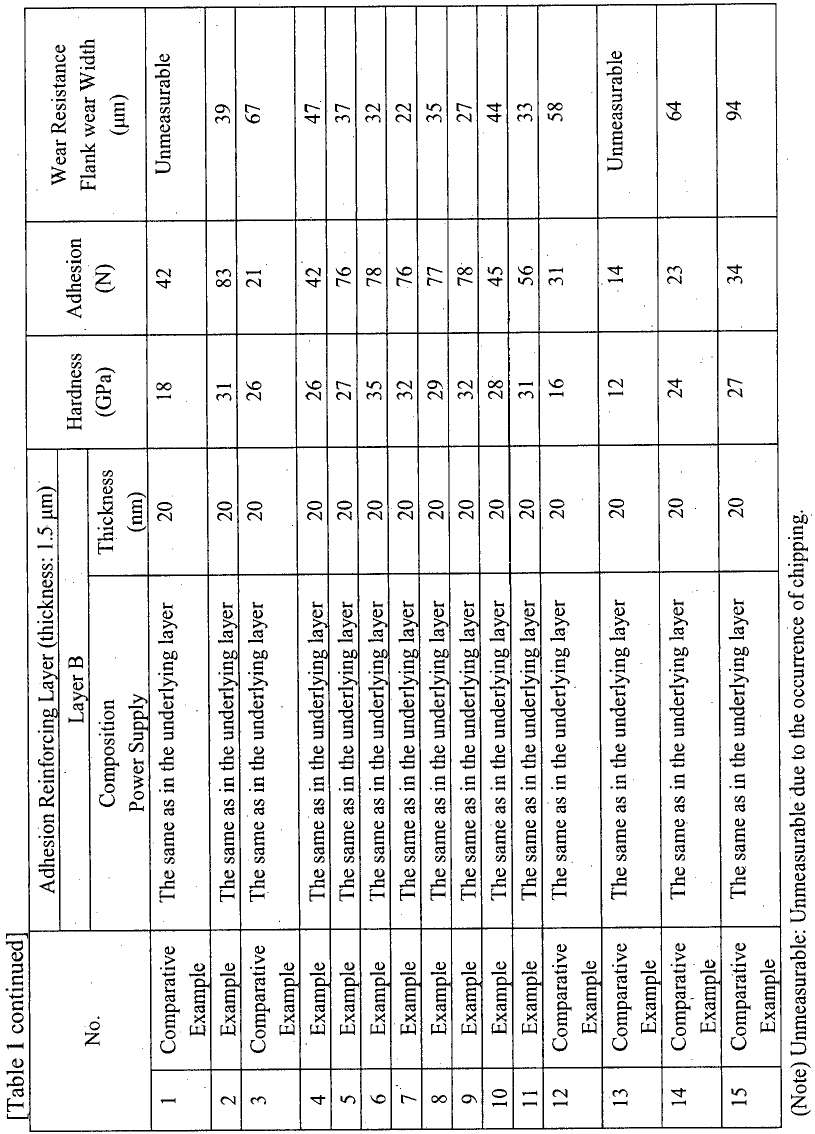

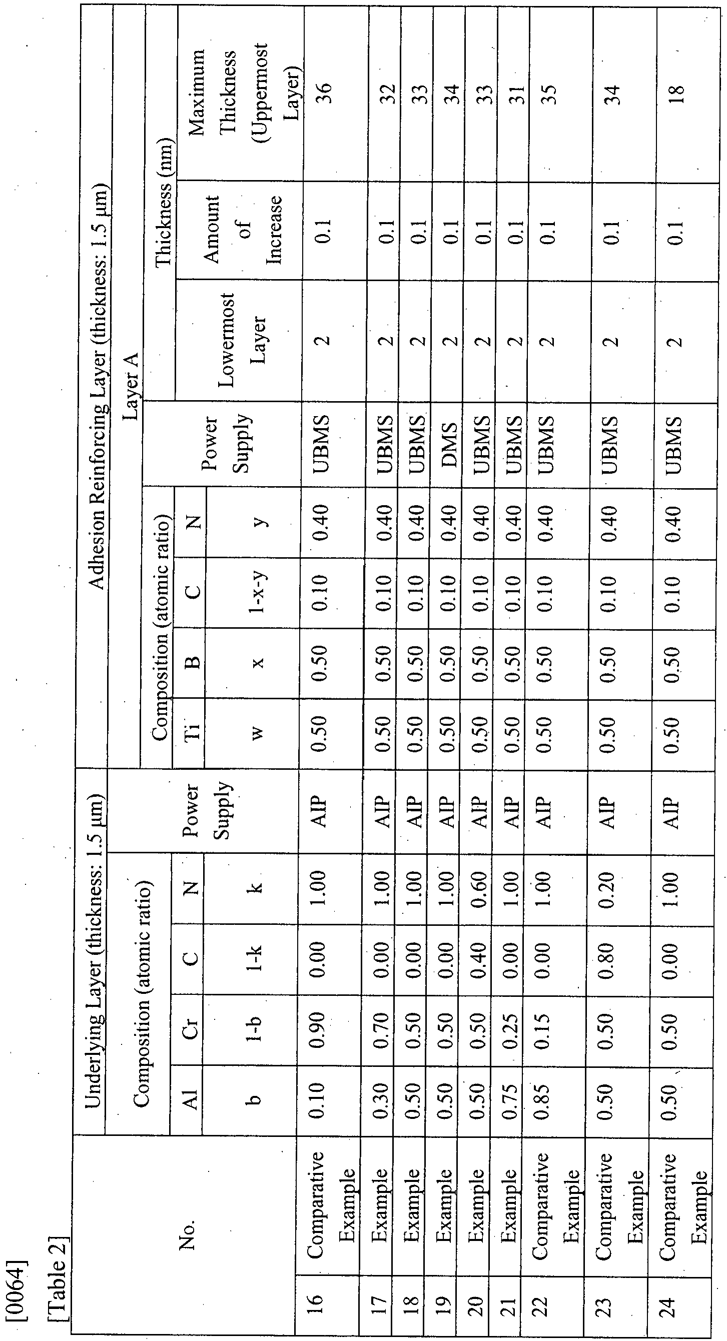

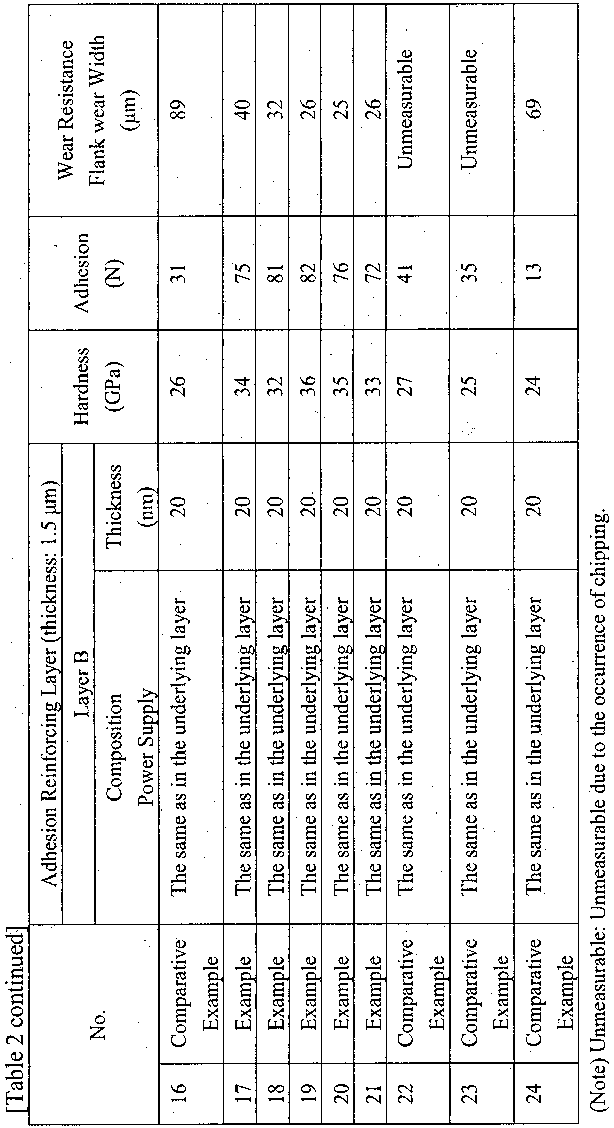

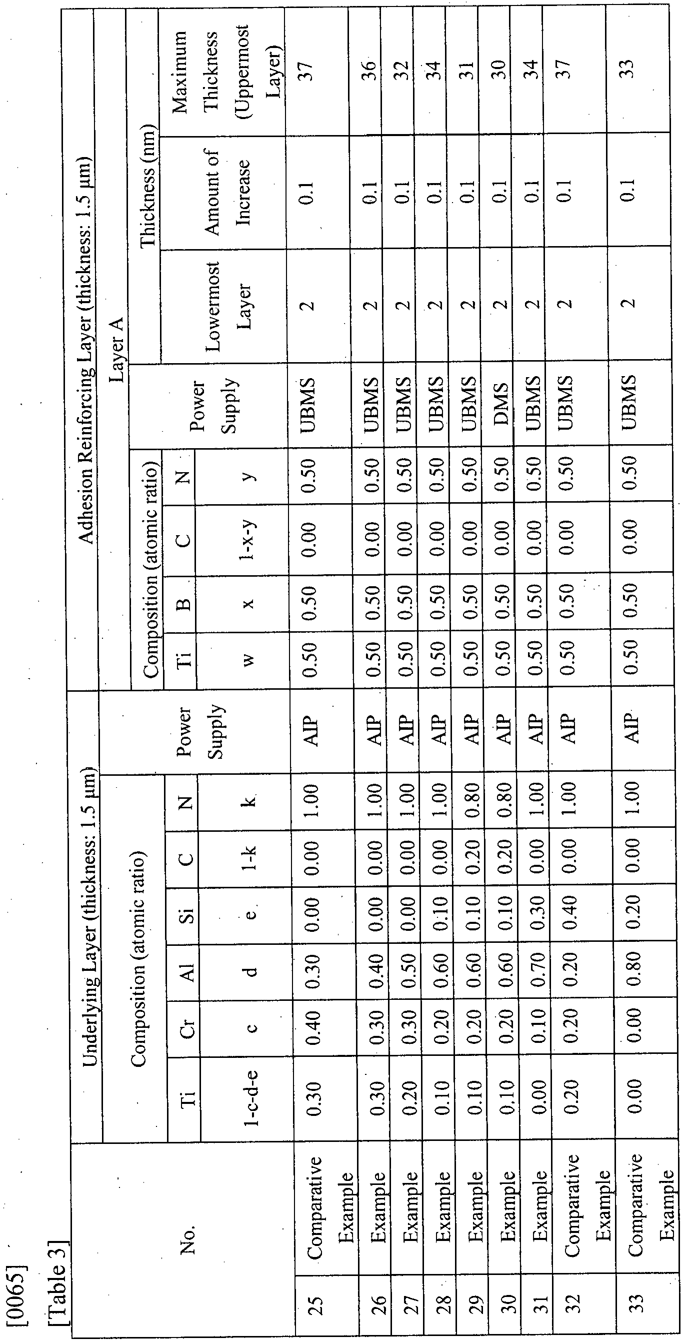

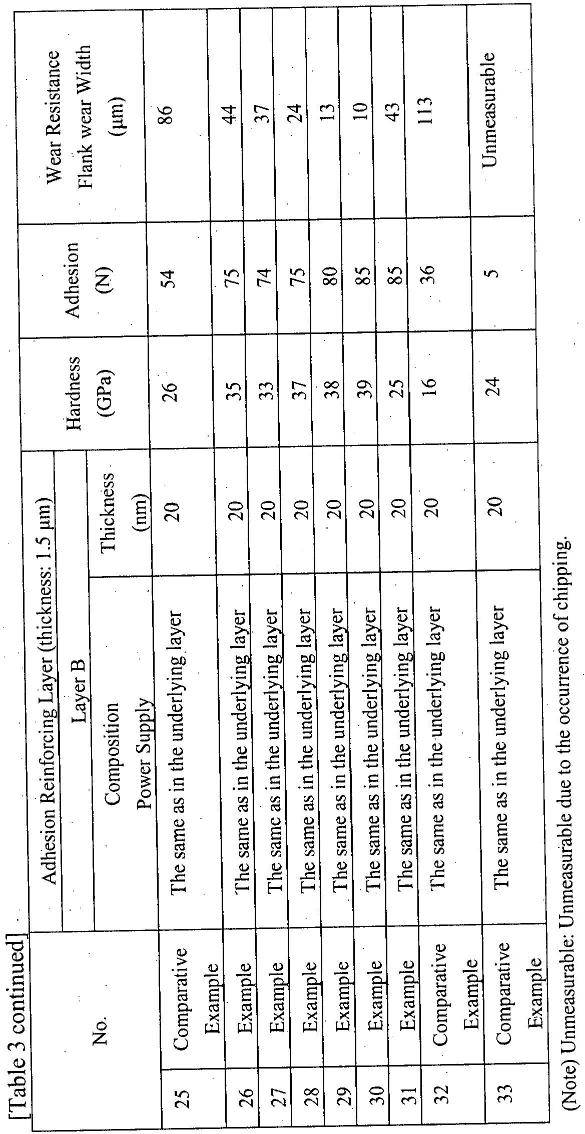

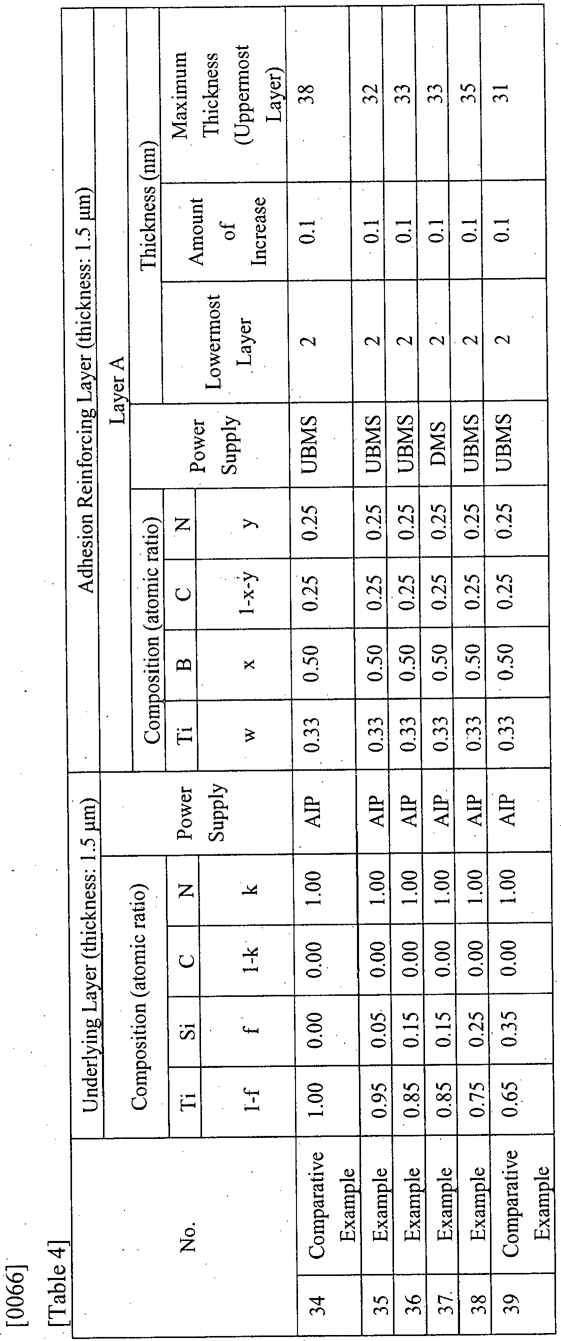

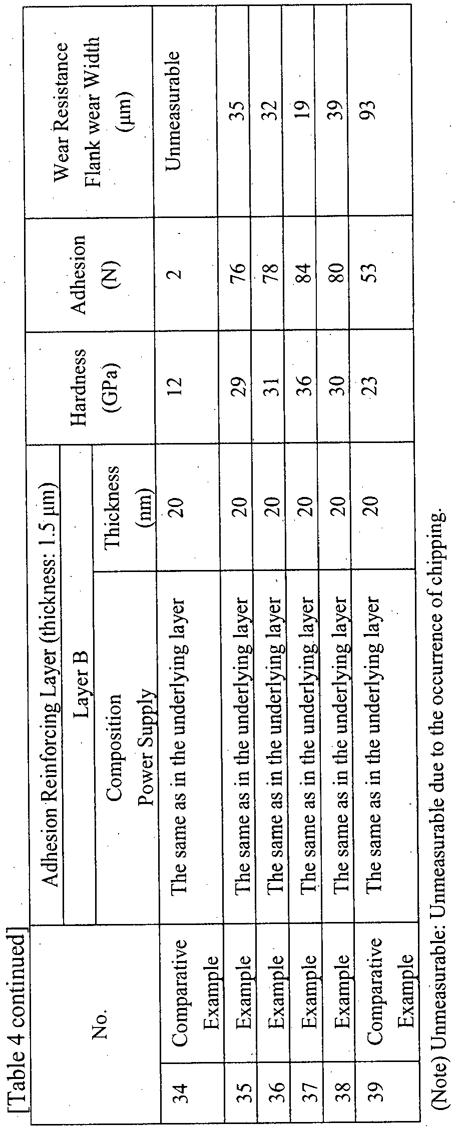

**[Table 5]**

| No. | | Layer B (thickness: 3.0 µm) | | Layer A (thickness: 3.0 µm) | | Hardness (GPa) | Adhesion (N) | Wear Resistance Flank wear Width (µm) |
|---|---|---|---|---|---|---|---|---|
| | | Composition (atomic ratio) | Power Supply | Composition (atomic ratio) | Power Supply | | | |
| 40 | Comparative Example | Ti_{0.50}Al_{0.50}N | AIP | - | DMS | 24 | 91 | 106 |
| 41 | Comparative Example | Al_{0.50}Cr_{0.50}N | AIP | - | DMS | 25 | 92 | 123 |
| 42 | Comparative Example | Ti_{0.10}Cr_{0.20}Al_{0.60}Si_{0.10}N | AIP | - | DMS | 29 | 94 | 79 |
| 43 | Comparative Example | Ti_{0.85}Si_{0.15}N | AIP | - | DMS | 31 | 100 | 86 |
| 44 | Comparative Example | - | AIP | Ti_{0.50}(B_{0.50}N_{0.50})_{0.50} | DMS | 14 | 3 | Unmeasurable |

| | | | | | | | | |
|---|---|---|---|---|---|---|---|---|
| (Note) Unmeasurable: Unmeasurable due to the occurrence of chipping. | | | | | | | | |

As sown in Table 1, in Nos. 2 and 4 to 11 (examples), the hard films satisfied the requirements of the present invention, so that the hardness, the adhesion and the wear resistance were good. On the other hand, in No. 1 (comparative example), Ti in the underlying layer and the layers B was less than the lower limit, and Al was more than the upper limit, so that the hardness and the wear resistance were poor. In No. 3 (comparative example), the thickness of the uppermost layer (the maximum thickness) of the layers A was less than the lower limit, so that the adhesion and the wear resistance were poor. In No. 12 (comparative example), Ti in the underlying layer and the layers B was more than the upper limit, and Al was less than the lower limit, so that the hardness, the adhesion and the wear resistance were poor. In No. 13 (comparative example), C in the underlying layer and the layers B was more than the upper limit, so that the hardness, adhesion and the wear resistance were poor. In No. 14 (comparative example), the layers A did not contain B, so that the hardness, adhesion and the wear resistance were poor. In No. 15 (comparative example), the layers A did not contain B, so that the adhesion and the wear resistance were poor.

As shown in Table 2, in Nos. 17 to 21 (examples), the hard films satisfied the requirements of the present invention, so that the hardness, the adhesion and the wear resistance were good. On the other hand, in No. 16 (comparative example), Al in the underlying layer and the layers B was less than the lower limit, and Cr was more than the upper limit, so that the adhesion and the wear resistance were poor. In No. 22 (comparative example), Al in the underlying layer and the layers B was more than the upper limit, so that the wear resistance was poor. In No. 23 (comparative example), C in the underlying layer and the layers B was more than the upper limit, so that the wear resistance was poor. In No. 24 (comparative example), the thickness of the uppermost layer (the maximum thickness) of the layers A was less than the lower limit, so that the hardness, the adhesion and the wear resistance were poor.

As shown in Table 3, in Nos. 26 to 31 (examples), the hard films satisfied the requirements of the present invention, so that the hardness, the adhesion and the wear resistance were good. On the other hand, in No. 25 (comparative example), Cr in the underlying layer and the layers B was more than the upper limit, so that the wear resistance was poor. In No. 32 (comparative example), Si in the underlying layer and the layers B was more than the upper limit, so that the hardness and the wear resistance were poor. In No. 33 (comparative example), Al in the underlying layer and the layers B was more than the upper limit, so that the hardness, the adhesion and the wear resistance were poor.

As shown in Table 4, in Nos. 35 to 38 (examples), the hard films satisfied the requirements of the present invention, so that the hardness, the adhesion and the wear resistance were good. On the other hand, in No. 34 (comparative example), the underlying layer and the layers B did not contain Si, so that the hardness, the adhesion and the wear resistance were poor. In No. 39 (comparative example), Ti in the underlying layer and the layers B was less than the lower limit, and Si was more than the upper limit, so that the hardness and the wear resistance was poor.

As shown in Table 5, in No. 40 (comparative example), the hard film was formed of the layers B alone, so that the hardness and the wear resistance were poor. In Nos. 41 to 43 (comparative examples), the hard films were formed of the layers B alone, so that the wear resistance was poor. In No. 44 (comparative example), the hard film was formed of the layers A alone, so that the hardness, the adhesion and the wear resistance were poor.

### <Second example>

In a second example, experiments of forming a layer C on an adhesion reinforcing layer and changing the thickness of the layer C were carried out. The film composition and the thickness of an underlying layer and the adhesion reinforcing layer were fixed. After the formation of the underlying layer having a thickness of 1.5 µm, layers A and layers B each having a thickness of 20 nm were alternately laminated on one another in the adhesion reinforcing layer, and the layers A were increased in thickness from 2 nm (the lowermost layer) to a maximum thickness of 30 nm (the uppermost layer), thereby forming the film so as to have a thickness of 1.5 µm as the adhesion reinforcing layer. Thereafter, the layer C was formed to have a thickness shown in Table 6. Then, the influence of the thickness of the layer C on the hardness, the adhesion and the wear resistance was examined.

Specifically, in the same manner as in the above-mentioned first example, the underlying layer and the adhesion reinforcing layer were formed on a substrate. Then, a TiB₂ target (target diameter: 152.4 mmφ) as a layer C target was attached to the sputter evaporation source. The substrate stage was rotated at rotation speed of 5 rpm, and a bias voltage of -40 V was applied to the substrate to evaporate the TiB₂ target, thereby forming the layer C having a predetermined thickness. For the formation of the layer A and the formation of the layer C, the UBMS power supply or the DMS power supply was used. Further, no adhesion reinforcing layer was formed on the underlying layer, and a bias voltage of -25 V was applied to the substrate to form only the layer C.

After the completion of the film formation, the component composition in the hard film was measured, and the hardness, the adhesion and the wear resistance were evaluated. The results thereof are shown in Table 6.

The measuring method of the component composition and the evaluation methods of the hardness, the adhesion and the wear resistance are the same as in the above-mentioned first example. For the component compositions in the hard film, the underlying layer was "Ti_{0.50}Al_{0.50}N", the layer A was "Ti_{0.50}(B_{0.50}N_{0.50})_{0.50}", and the layer B was "Ti_{0.50}Al_{0.50}N".

**[Table 6]**

| No. | | Layer A | | Underlying Layer, Layer B | Layer C | | | Hardness (GPa) | Adhesion (N) | Wear Resistance Flank wear Width (µm) |
|---|---|---|---|---|---|---|---|---|---|---|
| | | Composition (atomic ratio) | Power Supply | Composition (atomic ratio) | Composition | Thickness (µm) | Power Supply | | | |
| 45 | Example | Ti_{0.50}(B_{0.50}N_{0.50})_{0.50} | UBMS | Ti_{0.50}Al_{0.50}N | TiB₂ | 0.5 | UBMS | 30 | 81 | 37 |
| 46 | Example | Ti_{0.50}(B_{0.50}N_{0.50})_{0.50} | UBMS | Ti_{0.50}Al_{0.50}N | TiB₂ | 1 | UBMS | 33 | 82 | 23 |
| 47 | Example | Ti_{0.50}(B_{0.50}N_{0.50})_{0.50} | UBMS | Ti_{0.50}Al_{0.50}N | TiB₂ | 2 | UBMS | 34 | 84 | 12 |
| 48 | Example | Ti_{0.50}(B_{0.50}N_{0.50})_{0.50} | UBMS | Ti_{0.50}Al_{0.50}N | TiB₂ | 3 | UBMS | 38 | 82 | 10 |
| 499 | Example | Ti_{0.50}(B_{0.50}N_{0.50})_{0.50} | UBMS | Ti_{0.50}Al_{0.50}N | TiB₂ | 4 | UBMS | 47 | 75 | 24 |
| 50 | Example | Ti_{0.50}(B_{0.50}N_{0.50})_{0.50} | UBMS | Ti_{0.50}Al_{0.50}N | TiB₂ | 5 | UBMS | 45 | 73 | 47 |
| 51 | Example | Ti_{0.50}(B_{0.50}N_{0.50})_{0.50} | DMS | Ti_{0.50}Al_{0.50}N | TiB₂ | 0.6 | DMS | 38 | 95 | 13 |
| 52 | Comparative Example | Ti_{0.50}(B_{0.50}N_{0.50})_{0.50} | UBMS | Ti_{0.50}Al_{0.50}N | TiB₂ | 6 | UBMS | 49 | 68 | Unmeasurable |
| 53 | Comparative Example | - | - | Ti_{0.50}Al_{0.50}N | TiB₂ | 1 | UBMS | 27 | 21 | 92 |

| | | | | | | | | | | |
|---|---|---|---|---|---|---|---|---|---|---|
| (Note) Unmeasurable: Unmeasurable due to the occurrence of chipping. (Note) No. 53 had no adhesion reinforcing layer (layers A and layers B). | | | | | | | | | | |

As shown in Table 6, in Nos. 45 to 51 (examples), the hard films satisfied the requirements of the present invention, so that the hardness, the adhesion and the wear resistance were good. In No. 52 (comparative example), the thickness of the layer C was more than the upper limit, so that the wear resistance was poor. In No. 53 (comparative example), the hard film was formed of the underlying layer and the layer C, and no adhesion reinforcing layer was formed, so that the adhesion and the wear resistance was poor.

While the present invention has been described in detail with reference to specific embodiments, it will be apparent to those skilled in the art that various changes and modifications can be made without departing from the spirit and scope of the present invention.

This application is based on Japanese Patent Application No. 2014-032280 filed on February 21, 2014, the entire contents of which are incorporated herein by reference.

### DESCRIPTION OF REFERENCE NUMERALS AND SIGNS

- 1, 1A:: Hard film
- 2:: Underlying layer
- 3:: Adhesion reinforcing layer
- 4:: Layer A
- 5:: Layer B
- 6:: Layer C
- 10:: Substrate
- 100:: Film deposition apparatus
- 101:: Arc evaporation source
- 102:: Sputter evaporation source
- 103:: Chamber
- 104:: Gas supply port
- 105:: Substrate stage
- 106:: Heater
- 107:: Bias power supply
- 108:: Sputter power supply
- 109:: Arc power supply
- 110:: Filament
- 111:: AC power supply for filament heating
- 112:: DC power supply for discharge

## Claims

1. A hard film to be formed on a substrate, the hard film comprising:
a layer A having a composition of Ti_{w}(BₓC_{1-x-y}N_{y})_{1-w} satisfying
0.2≤w≤0.6
0.1≤x≤0.8,
0≤y≤0.5 and
0≤1-x-y≤0.5; and
a layer B having a composition of any one of Ti₁₋ₐAlₐ(C₁₋ₖNₖ), Al_{b}Cr_{1-b}(C₁₋ₖNₖ), Ti_{1-c-d-e}Cr_{c}Al_{d}Siₑ(C₁₋ₖNₖ) and Ti_{1-f}Si_{f}(C₁₋ₖNₖ), which satisfies
0.3≤a≤0.7,
0.3≤b≤0.8,
0.3≤d≤0.7,
c≤0.3,
0≤e≤0.3,
1-c-d-e≤0.3,
0.05≤f≤0.3 and
0.5≤k≤1,
wherein an underlying layer formed of the layer B is formed on the substrate, and an adhesion reinforcing layer in which the layers A and the layers B are alternately repeatedly laminated on one another is formed on the underlying layer, and
the layer A is increased in thickness compared to that on the underlying layer side with an increase in thickness of the adhesion reinforcing layer, and a maximum thickness of the layer A is 20 to 50 nm.

2. The hard film according to claim 1, wherein a layer C is further formed on the adhesion reinforcing layer, the layer C has a composition of TiB₂, and a thickness of the layer C is 5.0 µm or less.

3. A method for forming the hard film according to claim 1, the method comprising: a substrate preparation step of preparing the substrate; a substrate heating step of heating the substrate; and a film forming step of forming the hard film on the substrate,
wherein in the film forming step, the underlying layer and the adhesion reinforcing layer are formed by at least one of an arc ion plating process and a sputtering process.

4. A method for forming the hard film according to claim 2, the method comprising: a substrate preparation step of preparing the substrate; a substrate heating step of heating the substrate; and a film forming step of forming the hard film on the substrate,
wherein in the film forming step, the underlying layer, the adhesion reinforcing layer and the layer C are formed by at least one of an arc ion plating process and a sputtering process.
